# EUROPEAN PATENT SPECIFICATION

(11) **EP 2 887 134 B1**
(45) Date of publication and mention of the grant of the patent: **14.09.2016**
(21) Application number: 14190042.3
(22) Date of filing: 23.10.2014
(51) Int. Cl.: G02F 1/1333

(54) **Display device comprising displays and a heat radiation unit between the displays.**
Anzeigevorrichtung mit Bildschirmen und einer Wärmestrahlungseinheit zwischen den Bildschirmen.
Dispositif d'affichage comprenant des afficheurs et une unité de rayonnement de chaleur entre les afficheurs.

(30) Priority: 17.12.2013 KR 20130157551
(43) Date of publication of application: 24.06.2015
(73) Proprietor: Samsung Electronics Co., Ltd, Gyeonggi-do 443-742 (KR)
(72) Inventor: Kim, Hyung Ki, Seoul (KR); Ko, Tae Jun, Gyeonggi-do (KR); Kim, Seung Min, Gyeonggi-do (KR); Na, Jeong Shan, Gyeonggi-do (KR); Lee, Hyung Jin, Seoul (KR)
(74) Representative: Appleyard Lees IP LLP

(56) References cited:
- WO-A1-2012/035988
- WO-A1-2012/091530
- DE-A1- 10 332 012

## Description

### BACKGROUND

### 1. Field

Apparatuses consistent with exemplary embodiments relate to a display device constituting a video wall system and comprising adjacent displays having a heat radiation unit in between, the heat radiation unit decreasing the temperature of the displays.

### 2. Description of the Related Art

Display devices generally operate to display images on screens thereof. A variety of functions, such as a video wall function, may be achieved using the display devices. The video wall function refers to a function of perceiving a plurality of display devices as one single screen, by which an input image is enlarged to fit the size corresponding to, for example, 1×4, 2×2, 3×3, 4×4 screens or more.

The video wall function may be utilized in places such as business meeting rooms, presentations, exhibitions, traffic control or stock trading rooms to provide one large image on the screens of a plurality of display devices, thereby catching the attention of viewers more effectively.

However, the video wall system, in which neighboring display devices are connected in series, has a problem of an increase in temperature at contact portions between the neighboring display devices.

A display backlight employing light emitting diodes (LEDs) is classified as an edge type backlight and a direct type backlight according to positions of the LEDs. In the edge type backlight, the LEDs are positioned at a side of the display panel. In the direct type backlight, the LEDs are positioned under the display panel and have a surface area substantially identical to that of the display panel.

Therefore, in the case of a video wall system employing the edge type display devices, because the LEDs positioned at the side of the display panel are arranged adjacent to the LEDs of the neighboring display devices, temperature rises and, accordingly, lifespan of the display device is shortened.

DE10332012A1 discloses a display device comprising adjacent displays and an inner frame located between the adjacent displays. It mentions a heat dissipation system formed of fans and openings in a chassis enclosing the displays.

WO2012/091530A1 discloses a heat dissipation system for tiled displays based on air circulation.

### SUMMARY

The invention is defined by the appended claim. The disclosure provides a heat radiation unit capable of decreasing temperature of display devices constituting a video wall system and a display device having the heat radiation unit.

Further, it provides a heat radiation unit capable of decreasing temperature of a side surface of a display panel and a display device having the heat radiation unit.

Further still, it provides a heat radiation unit capable of preventing shortening of lifespan of the product by decreasing temperature of the display devices and a display device having the heat radiation unit.

In accordance with an aspect of an exemplary embodiment, there is provided a display device including: at least two displays arranged adjacent to each other and configured to output an image; and a heat radiation unit interposed between the displays and configured to radiate heat generated by the displays, wherein the heat radiation unit includes: a contact part contacting the displays; and a heat radiation part extending from the contact part and configured to radiate the heat generated by the displays.

The heat radiation unit may be a heat sink.

The heat radiation unit may further include an adhesive part that adheres the contact part to the displays.

The heat radiation part may include a heat radiation plate extending from the contact part and one or more heat radiation protrusions extending from the heat radiation plate.

The one or more heat radiation protrusions may extend from the contact part in a radial direction. The one or more heat radiation protrusions may have different heights.

The heat radiation unit may be a metal heat radiation plate.

Each of the displays may include a display module configured to display an image and a case provided at an outer portion of the display module. The heat radiation unit may be disposed at a side surface of the case.

In accordance with another aspect of the disclosure, there is provided a display device including at least two displays arranged adjacent to each other, wherein each of the displays includes a display module configured to display an image, and a case provided at an outer portion of the display module; and a heat radiation unit interposed between the displays so as to contact a side surface of the case of each of the displays and configured to radiate heat generated by the displays.

The heat radiation unit may be a heat sink.

The heat radiation unit may include a contact part contacting the side surface of the case of each of the displays and a heat radiation part extending from the contact part and configured to radiate heat generated by the displays.

The heat radiation unit may further include an adhesive part that adheres the contact part to the displays.

The heat radiation part may include a heat radiation plate extending from the contact part and one or more heat radiation protrusions extending from the heat radiation plate.

The one or more heat radiation protrusions may extend from the contact part in a radial direction by different inclination angles.

The one or more heat radiation protrusions may have different heights.

The heat radiation unit may be a metal heat radiation plate.

Each of the displays may include light emitting diodes (LEDs) provided in at least one of edge portions of the display module, and the heat radiation unit may be disposed at the side surface of the case adjacent to the LEDs.

### BRIEF DESCRIPTION OF THE DRAWINGS

The above and/or other aspects will become apparent and more readily appreciated from the following description of exemplary embodiments, taken in conjunction with the accompanying drawings of which:
FIG. 1 is a perspective view schematically illustrating a video wall system including a plurality of display devices according to an exemplary embodiment;
FIG. 2 is a view schematically illustrating the display device of the video wall system equipped with a heat radiation unit according to a first exemplary embodiment;
FIG. 3 is an exploded perspective view schematically illustrating the display device equipped with the heat radiation unit according to the first exemplary embodiment;
FIG. 4 is a sectional view schematically illustrating the display device equipped with the heat radiation unit according to the first exemplary embodiment;
FIG. 5 is a view schematically illustrating the display device including a heat radiation unit according to a second exemplary embodiment;
FIG. 6 is an exploded perspective view schematically illustrating the display device including the heat radiation unit according to the second exemplary embodiment;
FIG. 7 is a view schematically illustrating the display device including a heat radiation unit according to a third exemplary embodiment;
FIG. 8 is a view schematically illustrating the display device including a heat radiation unit according to a fourth exemplary embodiment; and
FIG. 9 is an exploded perspective view schematically illustrating the display device including the heat radiation unit according to the fourth exemplary embodiment.

### DETAILED DESCRIPTION

Reference will now be made in detail to the exemplary embodiments, examples of which are illustrated in the accompanying drawings, wherein like reference numerals refer to like elements throughout.

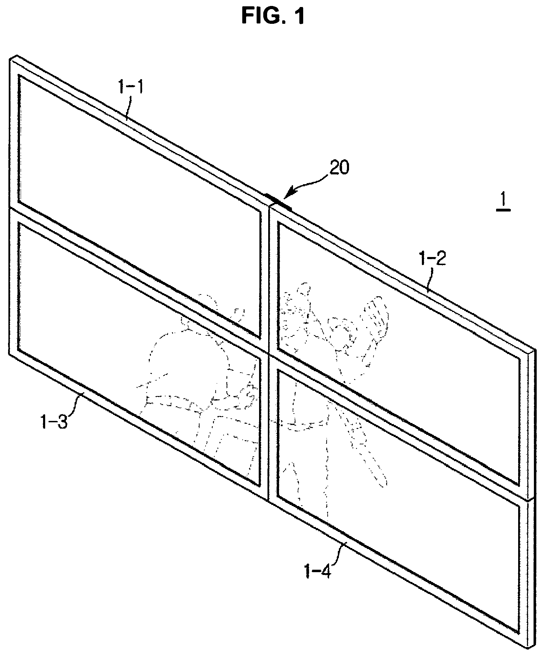

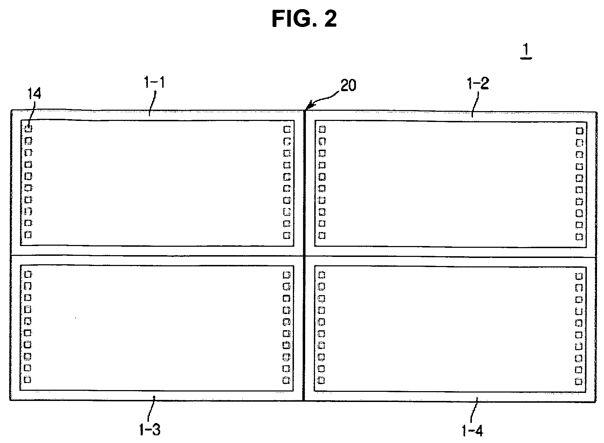

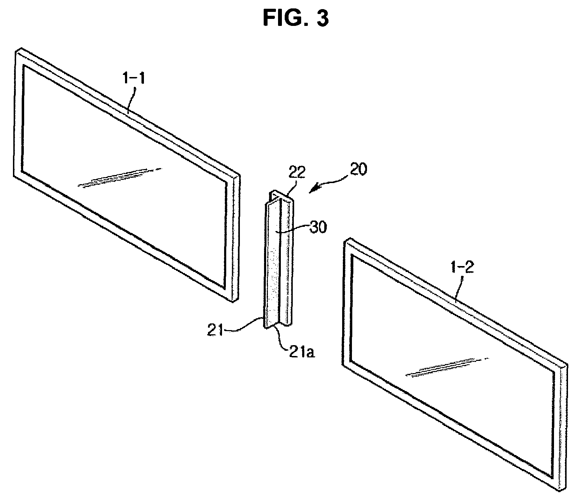

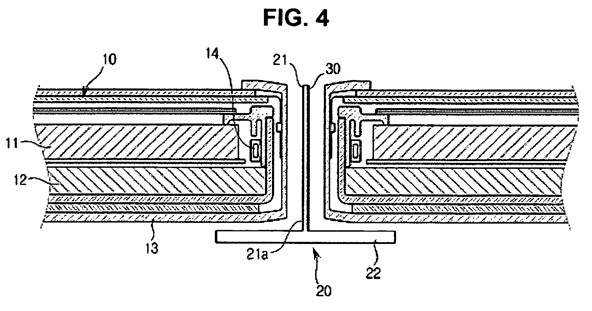

FIG. 1 is a perspective view schematically illustrating a video wall system including a plurality of display devices according to an exemplary embodiment, FIG. 2 is a view schematically illustrating the display device of the video wall system equipped with a heat radiation unit according to a first exemplary embodiment, FIG. 3 is an exploded perspective view schematically illustrating the display device equipped with the heat radiation unit according to the first exemplary embodiment, and FIG. 4 is a sectional view schematically illustrating the display device equipped with the heat radiation unit according to the first exemplary embodiment.

As illustrated in FIGS. 1 through 4, a display device 1 constituting a video wall system generally includes a plurality of displays, e.g., a first display 1-1, a second display 1-2, a third display 1-3 and a fourth display 1-4. For example, the plurality of displays 1-1, 1-2, 1-3 and 1-4 may be arranged in 2×2 matrix, i.e., two rows and two columns. However, the above example is provided for illustrative purposes only and, accordingly, the number and arrangement of the displays of a video wall system may vary.

The display device 1 of the video wall system may operate such that one of the displays 1-1, 1-2, 1-3 and 1-4 operates as a main display device to control operation of the other sub display devices. Alternatively, a separate control device (not shown) may be provided to control operation of the respective displays 1-1, 1-2, 1-3 and 1-4.

Each of the displays 1-1, 1-2, 1-3 and 1-4 includes a display module 10 to display image information and a case 13 provided at an outer portion of the display module 10 to protect the display module 10 and internal electric components.

The display module 10 may include a display panel to display an image. In general, the display panel may include a thin film transistor (TFT) substrate, a color filter substrate, and a liquid crystal layer disposed between the TFT substrate and the color filter substrate. Respective pixels emit light independently by driving circuits arranged in a matrix, thereby realizing an image.

A plurality of LEDs 14 may be provided as a light source and may be arranged at edge portions of the display module 10. The LEDs 14 may be arranged apart from each other with a regular interval therebetween in a longitudinal direction. Although it is described and illustrated in this exemplary embodiment that the LEDs 14 are arranged at both left and right edge portions of the display module 10, this and other embodiments are not limited thereto. For example, the LEDs may be arranged only at any one of both edge portions of the display module.

The case 13 is configured to cover the front edge portions and the rear surface of the display module 10. Within the case 13, there are provided a light guide plate 11 to convert incident light into a surface light source, a printed circuit board (PCB) 12 to control the display module 10, a power supply to supply power necessary to drive the display module 10, and a driving module to convert an electric signal from the outside into an image and sound.

The first display 1-1 and the second display 1-2 may be arranged adjacent to each other (side by side) in a horizontal direction. The third display 1-3 and the fourth display 1-4 may be arranged adjacent to each other (side by side) in a horizontal direction. The first display 1-1 and the third display 1-3 may be arranged adjacent to each other (stacked) in a vertical direction. The second display 1-2 and the fourth display 1-4 may be arranged adjacent to each other (stacked) in a vertical direction.

Heat radiation units 20 may be interposed between the first display 1-1 and the second display 1-2 and between the third display 1-3 and the fourth display 1-4.

Since the first display 1-1 and the second display 1-2 are arranged adjacent to each other in a horizontal direction, an internal temperature of the first and second displays 1-1 and 1-2 may rise due to heat generated from the LEDs 14 mounted to the edge portions of the first display 1-1 and the LEDs 14 mounted to the edge portions of the second display 1-2. That is, heat generated by the LEDs 14 of the first display 1-1 may cause the internal temperature of the second display 1-2 to rise and heat generated by the LEDs 14 of the second display 1-2 may cause the internal temperature of the first display 1-1 to rise.

The heat radiation unit 20 may be interposed between the case 13 of the first display 1-1 and the case 13 of the second display 1-2 to radiate heat generated from the first display 1-1 and the second display 1-2. Similarly, the heat radiation unit 20 may be interposed between the case 13 of the third display 1-3 and the case 13 of the fourth display 1-4 to radiate heat generated from the third display 1-4 and the fourth display 1-4.

Particularly, the heat radiation unit 20 is configured to radiate heat generated from the LEDs 14 between the first display 1-1 and the second display 1-2 and between the third display 1-3 and the fourth display 1-4, thereby decreasing temperature of the cases 13 around the LEDs 14.

The heat radiation unit 20 may include a metal heat radiation plate or a heat sink.

The heat radiation unit 20 includes a contact part 21 configured to contact the cases 13 of the displays 1-1, 1-2, 1-3 and 1-4 and a heat radiation part 22 extending from the contact part 21 and configured to radiate heat generated from the displays 1-1, 1-2, 1-3 and 1-4.

The contact part 21 may be configured with a contact surface 21a of the contact part 21 for contact with the case 13.

The heat radiation unit 20 may further include an adhesive part 30 provided at the contact surface 21a, by which the heat radiation unit 20 is adhered to the cases 13 of the displays 1-1, 1-2, 1-3 and. The adhesive part 30 may include an adhesive tape or an adhesive agent.

The heat radiation part 22 includes a heat radiation plate 23 extending from the contact part 21. The heat radiation plate 23 may extend from one end portion of the contact part 21 perpendicularly thereto and may be spaced apart from the rear surface of the case 13 of the first display 1-1 and the rear surface of the case 13 of the second display 1-2.

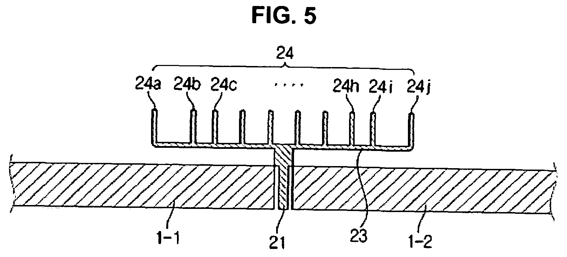

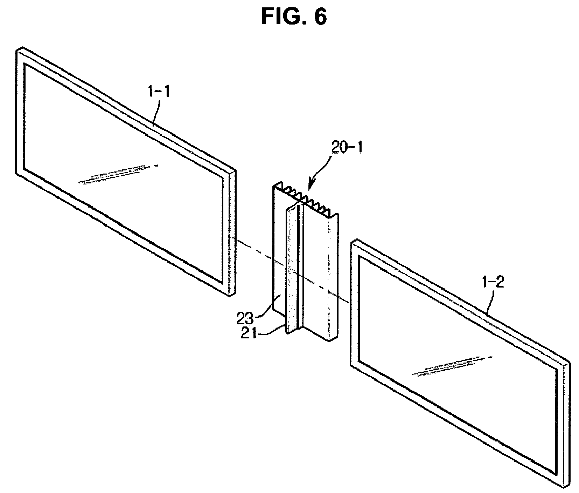

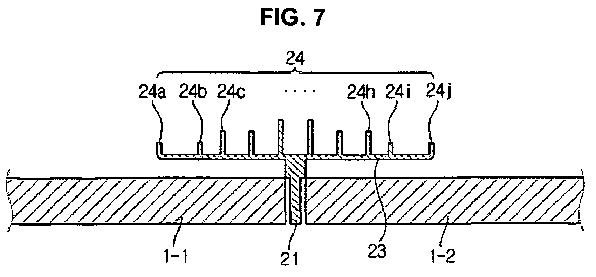

FIG. 5 is a view schematically illustrating the display device including a heat radiation unit according to a second exemplary embodiment, FIG. 6 is an exploded perspective view schematically illustrating the display device equipped with the heat radiation unit according to the second exemplary embodiment, and FIG. 7 is a view schematically illustrating the display device equipped with a heat radiation unit according to a third exemplary embodiment.

As illustrated in FIGS. 5 through 7, the heat radiation unit 20 includes a contact part 21 and a heat radiation part 22 extending from the contact part 21. The heat radiation part 22 may include a heat radiation plate 23 extending from the contact part 21 and one or more heat radiation protrusions 24 (24a, 24b, ..., 24i and 24j) extending from the heat radiation plate 23.

The heat radiation protrusions 24 extend outward from the heat radiation plate 23 and are spaced apart from each other, which causes effective convection flow of air between the heat radiation protrusions 24 and, accordingly, a heat radiation area is increased.

Since convection flow of air is easily created between the case 13 of the first display 1-1 and the case 13 of the second display 1-2 due to the heat radiation plate 23 and the heat radiation protrusions 24 of the heat radiation unit 20, heat radiation efficiency is enhanced.

The heat radiation protrusions 24 of the heat radiation unit 20 may respectively have different heights and thicknesses to enhance heat radiation efficiency. Although it is described and illustrated in the exemplary embodiment of FIG. 7 that the height of the heat radiation protrusions 24 gradually decreases from the center portion to the outermost portion and the thickness of the heat radiation protrusions 24 is the same, this and other embodiments are not limited thereto. For example, heat radiation protrusions with different heights may be diversely arranged.

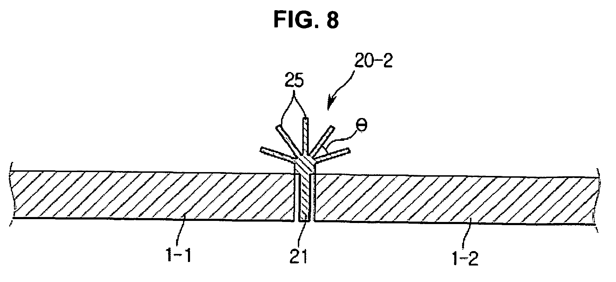

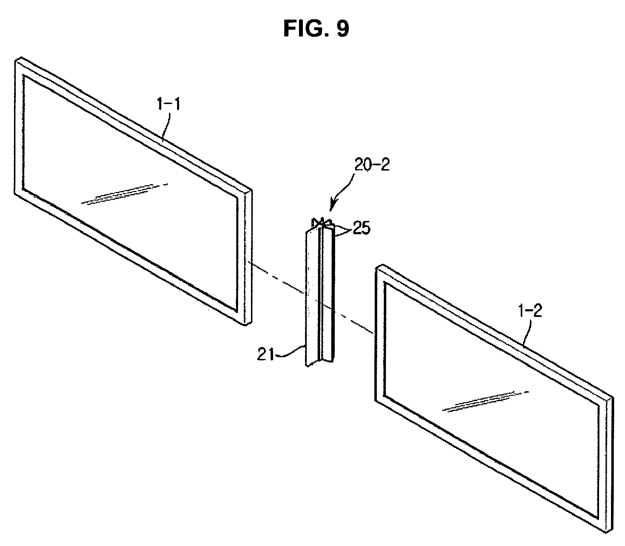

FIG. 8 is a view schematically illustrating the display device equipped with a heat radiation unit according to a fourth exemplary embodiment, and FIG. 9 is an exploded perspective view schematically illustrating the display device equipped with the heat radiation unit according to the fourth exemplary embodiment.

As illustrated in FIGS. 8 and 9, heat radiation protrusions 25 of the heat radiation unit 20 extend from one end portion of the contact part 21 in a radial direction by different inclination angles θ. In other words, the heat radiation protrusions 25 may have a fan shape.

Although it is described and illustrated in the embodiment of FIGS. 8 and 9 that the heat radiation protrusions 25 have the same height from the contact part 21 and the same thickness, this and other embodiments are not limited thereto. For example, the heat radiation protrusion located in the center portion may have the largest height, and the height of the heat radiation protrusions may gradually decrease to the outermost portion while the inclination angle increases.

Due to the heat radiation protrusions 25 having different angles and heights, convection flow of air is easily created between the heat radiation protrusions 25 and, accordingly, heat radiation efficiency is enhanced.

Although a few exemplary embodiments have been shown and described, it would be appreciated by those skilled in the art that changes may be made in these embodiments within the scope of the claims

## Claims

1. A display devic (1) comprising:
at least two displays (1-1, 1-2, 1-3, 1-4) arranged adjacent to each other and configured to output an image; and
a heat radiation unit (20) interposed between the displays and configured to radiate heat generated by the displays,
wherein the heat radiation unit comprises:
a contact part (21) placed between the displays and contacting the displays; and
a heat radiation part (22) extending from the contact part and configured to radiate the heat generated by the displays

2. The display device according to claim 1, wherein the heat radiation unit is a heat sink.

3. The display device according to claim 1, wherein the heat radiation unit further comprises an adhesive part (30) that adheres the contact part to the displays.

4. The display device according to claim 1, wherein the heat radiation part comprises a heat radiation plate (23) extending from the contact part and at least one heat radiation protrusion (24, 25) extending from the heat radiation plate.

5. The display device according to claim 4, wherein the at least one heat radiation protrusion comprises a plurality of heat radiation protrusions extending from the contact part in a radial direction.

6. The display device according to claim 4, wherein the at least one heat radiation protrusion comprises a plurality of heat radiation protrusions extending from the contact part and having different heights.

7. The display device according to claim 1, wherein the heat radiation unit is a metal heat radiation plate.

8. The display device according to claim 1, wherein each of the displays comprises a display module (10) configured to display an image and a case (13) provided at an outer portion of the display module, and
wherein the heat radiation unit is disposed at a side surface of the case of each of the displays.

## Patentansprüche

1. Anzeigevorrichtung (1), aufweisend:
mindestens zwei Anzeigen (1-1, 1-2, 1-3, 1-4), die nebeneinander angeordnet und konfiguriert sind, ein Bild auszugeben; und
eine Wärmestrahlungseinheit (20), die zwischen den Anzeigen eingeschoben und konfiguriert ist, Wärme abzugeben, die durch die Anzeigen erzeugt wird,
wobei die Wärmestrahlungseinheit aufweist:
einen Kontaktteil (21), der zwischen den Anzeigen angeordnet ist und die Anzeigen kontaktiert; und
einen Wärmestrahlungsteil (22), der sich von dem Kontaktteil erstreckt und konfiguriert ist, die Wärme abzustrahlen, die durch die Anzeigen erzeugt wird.

2. Anzeigevorrichtung nach Anspruch 1, wobei die Wärmestrahlungseinheit eine Wärmesenke ist.

3. Anzeigevorrichtung nach Anspruch 1, wobei die Wärmestrahlungseinheit ferner einen Klebstoffteil (30) aufweist, der den Kontaktteil an den Anzeigen anhaftet.

4. Anzeigevorrichtung nach Anspruch 1, wobei der Wärmestrahlungsteil eine Wärmestrahlungsplatte (23), die sich von dem Kontaktteil erstreckt, und mindestens einen Wärmestrahlungsvorsprung (24, 25), der sich von der Wärmestrahlungsplatte erstreckt, aufweist.

5. Anzeigevorrichtung nach Anspruch 4, wobei der mindestens eine Wärmestrahlungsvorsprung mehrere Wärmestrahlungsvorsprünge aufweist, die sich von dem Kontaktteil in einer Radialrichtung erstrecken.

6. Anzeigevorrichtung nach Anspruch 4, wobei der mindestens eine Wärmestrahlungsvorsprung mehrere Wärmestrahlungsvorsprünge aufweist, die sich von dem Kontaktteil erstrecken und unterschiedliche Höhen aufweisen.

7. Anzeigevorrichtung nach Anspruch 1, wobei die Wärmestrahlungseinheit eine metallische Wärmestrahlungsplatte ist.

8. Anzeigevorrichtung nach Anspruch 1, wobei jede der Anzeigen ein Anzeigemodul (10) aufweist, das konfiguriert ist, ein Bild anzuzeigen, und ein Gehäuse (13), das an einem äußeren Abschnitt des Anzeigemoduls vorgesehen ist, und
wobei die Wärmestrahlungseinheit an einer Seitenfläche des Gehäuses von jeder der Anzeigen angeordnet ist.

## Revendications

1. Dispositif d'affichage (1) comprenant :
au moins deux affichages (1-1, 1-2, 1-3, 1-4) agencés adjacents l'un à l'autre et configurés pour délivrer en sortie une image ; et
une unité de rayonnement de chaleur (20) interposée entre les affichages et configurée pour rayonner la chaleur générée par les affichages,
dans lequel l'unité de rayonnement de chaleur comprend :
une partie de contact (21) placée entre les affichages et venant au contact des affichages ; et
une partie de rayonnement de chaleur (22) s'étendant depuis la partie de contact et configurée pour rayonner la chaleur générée par les affichages.

2. Dispositif d'affichage selon la revendication 1, dans lequel l'unité de rayonnement de chaleur est un dissipateur thermique.

3. Dispositif d'affichage selon la revendication 1, dans lequel l'unité de rayonnement de chaleur comprend en outre une partie adhésive (30) qui fait adhérer la partie de contact aux affichages.

4. Dispositif d'affichage selon la revendication 1, dans lequel l'unité de rayonnement de chaleur comprend une plaque de rayonnement de chaleur (23) s'étendant depuis la partie de contact et au moins une saillie de rayonnement de chaleur (24, 25) s'étendant depuis la plaque de rayonnement de chaleur.

5. Dispositif d'affichage selon la revendication 4, dans lequel l'au moins une saillie de rayonnement thermique comprend une pluralité de saillies de rayonnement thermique s'étendant depuis la partie de contact dans une direction radiale.

6. Dispositif d'affichage selon la revendication 4, dans lequel l'au moins une saillie de rayonnement thermique comprend une pluralité de saillies de rayonnement thermique s'étendant depuis la partie de contact et ayant des hauteurs différentes.

7. Dispositif d'affichage selon la revendication 1, dans lequel l'unité de rayonnement de chaleur est une plaque métallique d'irradiation de chaleur.

8. Dispositif d'affichage selon la revendication 1, dans lequel chacun des affichages comprend un module d'affichage (10) configuré pour afficher une image et un boîtier (13) disposé au niveau d'une partie extérieure du module d'affichage,
et dans lequel l'unité de rayonnement thermique est disposée au niveau d'une surface latérale du boîtier de chacun des affichages.
